(19) Europäisches Patentamt / European Patent Office / Office européen des brevets

(11) **EP 2 106 612 B1**

(12) **FASCICULE DE BREVET EUROPEEN**

(45) Date de publication et mention de la délivrance du brevet:
**25.04.2018 Bulletin 2018/17**

(21) Numéro de dépôt: **07872012.5**

(22) Date de dépôt: **21.12.2007**

(51) Int Cl.:
*H01F 41/30* (2006.01)   *H01L 43/06* (2006.01)
*H01L 43/10* (2006.01)   *H01L 43/14* (2006.01)
*G11C 11/18* (2006.01)   *G11C 11/56* (2006.01)
*H01F 10/32* (2006.01)   *G01R 33/07* (2006.01)
*G01R 33/032* (2006.01)   *G01R 33/09* (2006.01)
*B82Y 25/00* (2011.01)   *B82Y 40/00* (2011.01)
*H01F 41/18* (2006.01)   *H01F 10/30* (2006.01)

(86) Numéro de dépôt international:
**PCT/FR2007/052602**

(87) Numéro de publication internationale:
**WO 2008/087345 (24.07.2008 Gazette 2008/30)**

(54) **DISPOSITIF MAGNÉTIQUE MULTICOUCHES, PROCÉDÉ POUR SA RÉALISATION, CAPTEUR DE CHAMP MAGNÉTIQUE, MÉMOIRE MAGNÉTIQUE ET PORTE LOGIQUE METTANT EN OEUVRE UN TEL DISPOSITIF**

MAGNETISCHE MEHRSCHICHTIGE VORRICHTUNG, VERFAHREN ZU DESSEN HERSTELLUNG, MAGNETFELDSENSOR, MAGNETISCHER SPEICHER UND LOGISCHES GATTER DIE EINE DERARTIGE VORRICHTUNG VERWENDEN

MULTILAYER MAGNETIC DEVICE, PROCESS FOR THE PRODUCTION THEREOF, MAGNETIC FIELD SENSOR, MAGNETIC MEMORY AND LOGIC GATE USING SUCH A DEVICE

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **26.12.2006 FR 0655943**

(43) Date de publication de la demande:
**07.10.2009 Bulletin 2009/41**

(73) Titulaire: **Commissariat à l'Énergie Atomique et aux Énergies Alternatives 75015 Paris (FR)**

(72) Inventeurs:
• **RODMACQ, Bernard**
  **F-38113 Veurey Voroize (FR)**
• **AUFFRET, Stéphane**
  **F-38410 Vaulnaveys Le Haut (FR)**
• **DIENY, Bernard**
  **F-38250 Lans En Vercors (FR)**
• **MORITZ, Jérôme**
  **F-38870 Saint Pierre De Bressieux (FR)**

(74) Mandataire: **Cabinet Laurent & Charras Le Contemporain 50 Chemin de la Bruyère 69574 Dardilly Cedex (FR)**

(56) Documents cités:
EP-A- 1 612 775      CN-A- 1 588 539
JP-A- H05 225 529      US-A1- 2006 221 510

• F. GARCIA ET AL: "Exchange-biased spin-valves with perpendicular magnetic anisotropy based on (C/Pt) multilayers" JOURNAL OF APPLIED PHYSICS, vol. 93, no. 10, 15 mai 2003 (2003-05-15), pages 8397-8399, XP002446999
• RODMACQ B ET AL: "CROSSOVERS FROM IN-PLANE TO PERPENDICULAR ANISOTROPY IN MAGNETIC TUNNEL JUNCTIONS AS A FUNCTION OF THE BARRIER DEGREE OF OXIDATION" JOURNAL OF APPLIED PHYSICS, AMERICAN INSTITUTE OF PHYSICS. NEW YORK, US, vol. 93, no. 10, PART 03, 15 mai 2003 (2003-05-15), pages 7513-7515, XP001166064 ISSN: 0021-8979

- NAWRATH T ET AL: "MAGNETIC ANISOTROPIES AND MAGNETOTRASPORT IN CEH2/CO MULTILAYERS" PHYSICAL REVIEW, B. CONDENSED MATTER, AMERICAN INSTITUTE OF PHYSICS. NEW YORK, US, vol. 55, no. 5, PART 01, 1 février 1997 (1997-02-01), pages 3071-3082, XP000658410 ISSN: 0163-1829
- OHNUMA ET AL: "Soft magnetic multilayers for micromagnetic devices", JOURNAL OF MAGNETISM AND MAGNETIC MATERIALS, vol. 126, no. 1-3, 1 September 1993 (1993-09-01), pages 556-562, XP024464178, ISSN: 0304-8853, DOI: 10.1016/0304-8853(93)90687-W [retrieved on 1993-09-01]

**Description**

**DOMAINE TECHNIQUE DE L'INVENTION**

La présente invention se rattache au domaine des matériaux magnétiques, plus particulièrement destinés à être mis en oeuvre en tant que capteurs de champ magnétique, ou au sein des mémoires magnétiques à accès aléatoire non volatiles, permettant le stockage et la lecture de données dans des systèmes électroniques, voire dans la réalisation d'éléments utilisables dans le domaine de la logique magnétique reprogrammable.

**ETAT ANTERIEUR DE LA TECHNIQUE**

Une des applications visées par la présente invention concerne des dispositifs magnétiques permettant la détection de champs magnétiques basée sur la mesure de l'Effet Hall Extraordinaire.

Il existe deux types d'Effets Hall : l'Effet Hall Ordinaire et l'Effet Hall Extraordinaire. L'Effet Hall Ordinaire existe dans les matériaux métalliques ou semi-conducteurs dopés, et est dû à la force de Lorentz agissant sur les électrons sous l'effet d'un champ magnétique. L'Effet Hall Extraordinaire existe limitativement dans les matériaux ferromagnétiques et résulte de la diffusion des électrons par interaction spin-orbite avec les moments magnétiques du matériau ferromagnétique.

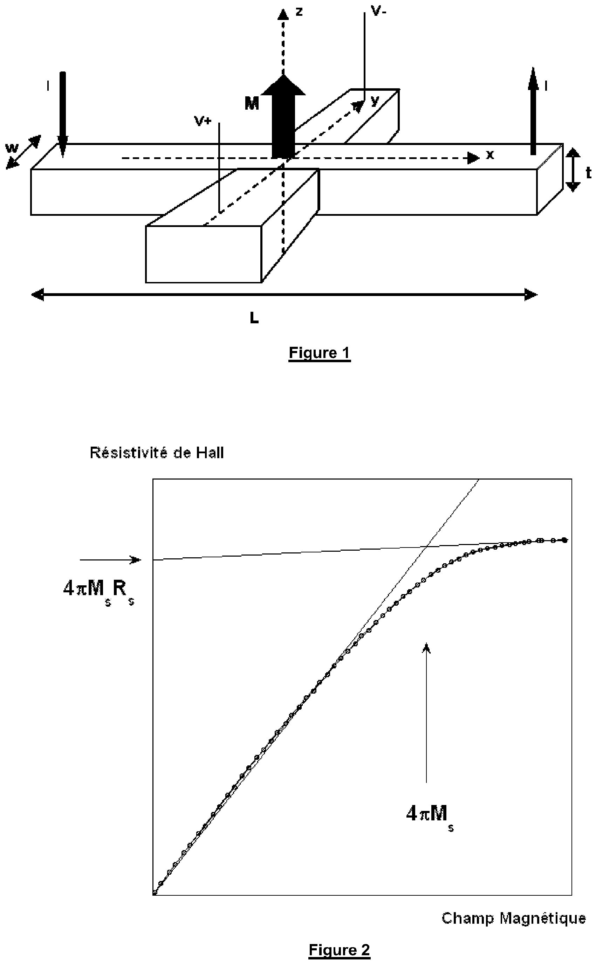

La figure 1 est une représentation parmi d'autres d'une géométrie de mesure de l'Effet Hall. Elle schématise une croix réalisée en un matériau ferromagnétique, de longueur $\underline{L}$ (selon l'axe x), de largeur $\underline{w}$ (selon l'axe y) et d'épaisseur $\underline{t}$ (selon l'axe z), parcourue par un courant $\underline{I}$ selon l'axe x, et soumise à un champ magnétique $\underline{H}$ perpendiculaire au plan (x, y). Sous l'effet de la force de Lorentz résultant du champ magnétique appliqué et des interactions spin-orbite couplant les trajectoires électroniques avec l'aimantation locale du matériau, les lignes de courant se courbent dans la direction transverse à la direction du courant et une tension, dite tension de Hall, va apparaître afin de rétablir l'équilibre. Cette tension est mesurée perpendiculairement au sens du courant, soit selon la direction y.

Un paramètre caractéristique de l'effet Hall est la résistivité de Hall, qui s'exprime selon l'expression :

$$\rho_{xy} = (V_{xy} / I)t = R_0 H + 4\pi R_s M_z \tag{1}$$

où :

- $V_{xy}$ est la tension de Hall mesurée dans le plan (L, w) suivant une direction perpendiculaire à celle du courant électrique,
- I est l'intensité du courant injecté,
- t est l'épaisseur du film mince,
- $R_0$ est le coefficient de Hall Ordinaire,
- H est l'amplitude du champ magnétique appliqué,
- $R_s$ est le coefficient de Hall Extraordinaire et $M_z$ est la composante perpendiculaire de l'aimantation du film mince.

D'autre part, le courant I circulant dans le film mince génère une tension longitudinale selon l'expression :

$$V_{xx} = RI \tag{2}$$

où $R = \rho_{xx} L/(wt)$ est la résistance du matériau et $\rho_{xx}$ sa résistivité électrique longitudinale (parallèlement à la direction du courant I). En combinant les relations (1) et (2), on obtient:

$$V_{xy}/V_{xx} = (w/L)\ \rho_{xy}/\rho_{xx} \tag{3}$$

où $\rho_{xy}/\rho_{xx}$ est un paramètre sans dimension appelé angle de Hall, caractérisant la capacité du matériau à dévier le flot d'électrons par rapport à la direction du champ électrique longitudinal. Sa valeur est de l'ordre de quelques pour cent pour les matériaux magnétiques usuels. w/L est un facteur géométrique qui peut être au plus de l'ordre de 1.

Le premier terme de l'équation (1), $R_0 H$, correspond à la résistivité de Hall Ordinaire, et le second terme, $4\pi R_s M_z$, correspond à la résistivité de Hall Extraordinaire. Pour des champs magnétiques relativement faibles, l'Effet Hall Ordinaire est généralement plusieurs ordres de grandeur plus faible que l'Effet Hall Extraordinaire, et peut donc être négligé.

Si l'aimantation du film ferromagnétique est parallèle au plan, ce qui est généralement le cas pour des couches minces, sa composante perpendiculaire $M_z$ augmente linéairement avec le champ magnétique appliqué, jusqu'à atteindre l'aimantation à saturation $M_s$. Donc, tant que $M_z$ est inférieur à $M_s$, la tension de Hall Extraordinaire est proportionnelle au champ magnétique appliqué.

La figure 2 représente schématiquement la variation de la résistivité de Hall avec le champ magnétique appliqué. Pour $H < 4\pi M_s$, la résistivité varie linéairement avec le champ appliqué, jusqu'à atteindre $\rho_{xy} = 4\pi R_s M_s$. Au-delà, la résistivité varie linéairement avec le champ appliqué avec une pente $R_0$ (premier terme de l'équation (1)) beaucoup plus faible comme indiqué précédemment. La région utile de fonctionnement d'un capteur de champ magnétique basé sur ce principe est donc limitée à des valeurs de champ magnétique inférieures à $4\pi M_s$, où $M_s$ est l'aimantation à saturation du matériau magnétique considéré.

C'est la pente de la courbe $\rho_{xy}(H)$ qui détermine la sensibilité du champ magnétique d'un tel capteur, exprimée en micro-ohm centimètre par Tesla ($\mu\Omega$cm/T). Cette pente peut également, compte tenu de l'épaisseur t du film mince, et suivant la relation $\rho_{xy} = t \times R_{xy}$, être exprimée en ohm par Tesla ($\Omega$/T). Afin de maximiser cette pente, on peut, soit augmenter le terme $R_s$ d'Effet Hall Extraordinaire, soit diminuer l'anisotropie magnétique planaire du matériau afin de réduire le champ de saturation perpendiculaire.

Il y a deux mécanismes de diffusion spin-orbite impliqués dans l'Effet Hall Extraordinaire, dénommés sous l'expression anglo-saxonne « *skew scattering* » (littéralement "diffusion de travers") et « *side-jump effect* » (littéralement "saut de côté").

Le coefficient d'Effet Hall Extraordinaire $R_s$ peut s'écrire en conséquence de la façon suivante:

$$R_s = a\rho_{xx} + b\rho_{xx}^2 \qquad\qquad (4)$$

où $\rho_{xx}$ représente la résistivité longitudinale, et a et b sont des constantes positives. Le premier terme de la relation (4) correspond au "*skew scattering*", et domine généralement dans les alliages dilués à basse température. Le deuxième terme, lié à l'effet "*side-jump*", est plus important dans les alliages à forte concentration d'impuretés et à haute température.

On voit donc que le choix d'un matériau à forte résistivité longitudinale et à forte diffusion spin-orbite est favorable pour maximiser $R_s$. Cette forte résistivité longitudinale est également un avantage car elle permet, pour des dispositifs de petite taille, de conserver une réponse en tension suffisante tout en limitant le courant circulant dans ledit dispositif à des valeurs supportables, au dessous d'une valeur entraînant des modifications structurales irréversibles (phénomènes d'électromigration).

La forte résistivité longitudinale est obtenue, soit en augmentant le désordre atomique du matériau (alliage désordonné par exemple), soit en diminuant l'épaisseur du film (il est connu que, pour une couche très mince, la résistivité électrique varie approximativement comme l'inverse de l'épaisseur du film). La contribution de diffusion spin-orbite est augmentée par un choix de matériau contenant des éléments de numéro atomique élevé, par exemple le platine, le palladium, l'or, ou les métaux de la série des Terres Rares.

Il faut néanmoins remarquer que l'incorporation de tels matériaux est forcément limitée en concentration afin de conserver de bonnes propriétés magnétiques à l'alliage ferromagnétique.

Un deuxième moyen d'augmenter la pente de la courbe $\rho_{xy}(H)$ est de diminuer l'anisotropie magnétique planaire du matériau, c'est-à-dire d'introduire un terme supplémentaire de signe opposé au terme classique $4\pi M_s$. Ce terme noté $H_S$ peut avoir pour origine soit une anisotropie volumique d'origine magnétocristalline ou induite par des contraintes élastiques de croissance, soit une anisotropie d'interface due à des interactions électroniques interfaciales. Un cas typique est par exemple l'influence d'une couche de platine au contact d'une couche magnétique de cobalt, de nickel ou de fer.

En présence de ce terme supplémentaire, le champ d'anisotropie perpendiculaire $H_K$ peut s'écrire de la façon suivante:

$$H_K = 4\pi M_s - H_S \qquad\qquad (5)$$

D'une manière qualitative, le champ d'anisotropie perpendiculaire $H_K$ va donc diminuer de façon régulière lorsque $H_S$ va augmenter, l'aimantation de la couche magnétique étant toujours parallèle au plan, jusqu'à tendre vers zéro, limite en deçà de laquelle, lorsque $H_S$ est supérieur à $4\pi M_s$, l'aimantation de la couche magnétique est spontanément (c'est à dire sans champ magnétique appliqué) perpendiculaire au plan de la couche. Dans ce dernier cas le matériau magnétique possède deux états stables en champ nul, et peut donc être intégré dans des dispositifs tels que mémoires magnétiques ou portes logiques magnétiques.

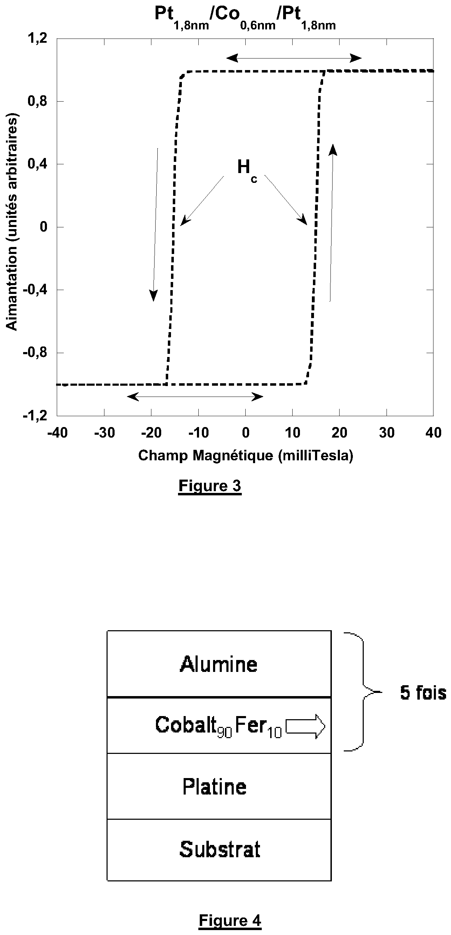

La figure 3 est une représentation schématique de la courbe d'aimantation obtenue dans cette situation, pour un échantillon typique de composition $Pt_{1,8nm}/Co_{0,6nm}/Pt_{1,8nm}$. Cette courbe peut être obtenue soit par mesure classique de magnétométrie, soit par mesure de l'Effet Hall, soit encore par mesure de l'Effet Kerr ou de l'Effet Faraday magnéto-optique. Les flèches indiquent le sens de parcours du cycle magnétique lorsque l'on applique l'excitation magnétique H indiquée en abscisse. Les flèches monodirectionnelles représentent les évolutions irréversibles des cycles, tandis que les flèches bidirectionnelles représentent leurs évolutions réversibles. En ordonnée, les niveaux d'aimantation sont donnés en unités arbitraires.

En réduisant progressivement le champ magnétique appliqué d'une valeur positive, par exemple, à une valeur nulle, l'aimantation de la couche magnétique reste perpendiculaire à son plan et orientée dans le sens de ce champ magnétique précédemment appliqué. Il est alors nécessaire d'appliquer un champ magnétique de sens opposé, d'amplitude plus ou moins grande, afin de réorienter l'aimantation de la couche, toujours dans une direction perpendiculaire au plan, mais dans un sens opposé, à savoir dans le sens de ce nouveau champ magnétique appliqué.

Le champ magnétique nécessaire à ce basculement, plus précisément le champ magnétique qu'il faut appliquer pour que l'aimantation, moyennée sur l'ensemble des domaines magnétiques, soit nulle, est appelé champ coercitif, et dénommé $H_c$ sur la figure 3. La valeur de ce champ coercitif va déterminer la stabilité de l'aimantation, dans un sens ou dans l'autre, vis à vis des perturbations magnétiques extérieures.

Plus ce champ coercitif est fort, plus le matériau est stable vis à vis de ces perturbations. Mais aussi, dans ce cas, plus il est difficile de modifier intentionnellement la direction de l'aimantation, comme par exemple dans le cadre de l'utilisation de ce matériau en tant que mémoire magnétique, pour laquelle l'information est justement codée par le sens de l'aimantation.

On peut donc préférer un champ coercitif faible nécessitant moins d'énergie pour réussir à faire basculer l'aimantation, avec peut-être dans ce cas nécessité de "blinder" magnétiquement le dispositif vis à vis des perturbations magnétiques extérieures, ou alors préférer un champ coercitif fort, ce qui rend le dispositif plus stable mais plus consommateur d'énergie.

Il faut également mentionner que l'on peut utiliser d'autres façons de déterminer l'orientation et l'amplitude de l'aimantation d'une couche magnétique.

On peut par exemple mesurer la résistance électrique d'une tricouche formée de deux couches magnétiques indépendantes séparées par un métal non magnétique ou par une couche d'oxyde, l'aimantation d'une des deux couches magnétiques étant piégée dans une direction déterminée. La résistance électrique de cet empilement est plus faible dans le cas où les deux aimantations sont parallèles, comparé au cas où les aimantations sont anti-parallèles (phénomène bien connu de magnétorésistance géante ou tunnel).

On peut également utiliser les effets magnéto-optiques, dans lesquels l'interaction entre la lumière incidente et les moments magnétiques de la couche magnétique provoque une rotation du plan de polarisation de la lumière incidente ainsi qu'une modification de son ellipticité.

Il existe dans la littérature quelques matériaux qui peuvent présenter certaines des caractéristiques exposées ci-dessus.

On peut citer par exemple les systèmes multicouches bien connus cobalt/platine, qui présentent une forte anisotropie magnétique perpendiculaire. En fonction des épaisseurs des couches élémentaires de platine et de cobalt, du nombre de répétitions du motif (Co/Pt) et de la présence d'une couche tampon de platine, on peut obtenir, soit un système présentant une aimantation spontanément (en champ magnétique nul) perpendiculaire au plan des couches, soit une aimantation dans le plan des couches mais présentant une très forte susceptibilité magnétique perpendiculaire (pente de la courbe $M_z = f(H)$). Malheureusement ces matériaux présentent une résistivité longitudinale faible, due à la faible résistivité de ses composants métalliques.

Un autre exemple, décrit dans la publication de T. W. Kim, S. H. Lim, R. J. Gambino, "Spontaneous Hall effect in amorphous Tb-Fe and Sm-Fe thin films", Journal of Applied Physics, 2001, Vol. 89, p. 7212, concerne les alliages RE-TM, dans lesquels RE désigne un élément de la famille des Terres Rares (Gd, Tb, Sm), et TM un élément magnétique de Transition (Fe, Co, Ni ou leurs alliages). Ces matériaux présentent un angle de Hall élevé (de l'ordre de 4%), une résistivité longitudinale plus forte que dans le cas précédent, mais par contre une sensibilité au champ magnétique faible, de l'ordre de 0,4 $\Omega$/T.

Les alliages de platine et d'un Métal de Transition magnétique (Fe, Co, Ni) présentent quant à eux des sensibilités au champ magnétique plus fortes, de l'ordre de 4 $\Omega$/T, et des résistivités longitudinales de l'ordre de 100$\mu\Omega$cm (voir par exemple G. X. Miao, Gang Xiao, "Giant Hall resistance in Pt-based ferromagnetic alloys", Applied Physics Letters, 2004, Vol. 85, p. 73).

On atteint à peu près des sensibilités au champ équivalentes avec des alliages d'un matériau magnétique et d'un oxyde, par exemple $Ni-SiO_2$ (voir A. B. Pakhomov, X. Yan, B. Zhao, "Giant Hall effect in percolating ferromagnetic granular metal-insulator films", Applied Physics Letters, 1995, Vol. 67, p. 3497). Dans ce cas, l'avantage réside dans la résistivité longitudinale très élevée, de l'ordre de $10^5$ à $10^8$ $\mu\Omega$cm, mais l'angle de Hall est faible (quelques 0,1 %) et le rapport signal sur bruit médiocre.

Finalement, des sensibilités au champ magnétique très élevées (300 $\Omega$/T) ont été obtenues dans des films minces de nickel. Malheureusement cette sensibilité, obtenue à basse température (-100°C), diminue très rapidement pour atteindre une valeur quasi nulle à température ambiante, ce qui limite considérablement le domaine d'application de ces matériaux (voir O. Riss, A. Tsukernik, M. Karpovsky, A. Gerber, "Reorientation phase transition and sensitivity of the extraordinary Hall-effect-based sensors", Journal of Magnetism and Magnetic Materials, 2006, Vol. 298, p. 73).

Il résulte de ces considérations qu'aucun des matériaux magnétiques connus actuellement ne rassemble toutes les propriétés nécessaires à son utilisation en tant que capteur de champ magnétique ou mémoire magnétique, à savoir forte résistivité longitudinale (au moins quelques centaines de $\mu\Omega$cm), forte résistivité de Hall (quelques pour cent de la résistivité longitudinale) et forte susceptibilité magnétique perpendiculaire (au moins dix fois plus forte que pour un matériau magnétique classique à aimantation planaire, c'est-à-dire avec un champ de saturation hors du plan au plus de l'ordre de quelques dizaines de milliTeslas), voire même aimantation perpendiculaire en champ nul pour les applications de type mémoires magnétiques ou portes logiques magnétiques. A cet égard, on peut rappeler que les capteurs de champ magnétique semi-conducteurs présentent actuellement des sensibilités au champ magnétique de l'ordre de quelques 100 $\Omega$/T.

Sur un autre plan, des empilements de couches s'apparentant à ceux de la présente invention ont déjà été proposés dans la littérature, mais pas dans un but d'application dans des dispositifs de type capteurs de champ magnétique, mémoires magnétiques ou composants logiques magnétiques.

On peut en premier lieu citer des travaux concernant des multicouches composées de couches de cobalt alternant avec des couches d'alumine ($Al_2O_3$) (voir Ch. Morawe, H. Zabel, "*Structure and thermal stability of sputtered metal/oxide multilayers: the case of Co/Al$_2$O$_3$*", Journal of Applied Physics, 1995, Vol. 77, p. 1969). Dans cette publication, les auteurs ne mentionnent aucune éventuelle propriété d'anisotropie magnétique perpendiculaire de ces matériaux, objet de la présente invention.

De plus, ces auteurs ne destinent absolument pas, contrairement à la présente invention, ces matériaux à une utilisation dans le domaine des capteurs de champ magnétique ou des mémoires ou composants logiques magnétiques basés notamment sur la mesure de l'Effet Hall Extraordinaire. En effet, les auteurs proposent d'utiliser ces matériaux uniquement pour leurs propriétés structurales dans le cadre de miroirs pour les rayons X. Ces travaux ne relèvent donc pas du champ d'application visé par la présente invention.

On peut également citer des travaux concernant des multicouches "discontinues" composées de couches de cobalt ou d'alliages cobalt-fer alternant avec des couches de silice $SiO_2$ ou d'alumine $Al_2O_3$ (voir B. Dieny, S. Sankar, M. R. McCartney, D. J. Smith, P. Bayle-Guillemaud, A. E. Berkowitz, "Spin-dependent tunnelling in discontinuous metal/insulator multilayers", Journal of Magnetism and Magnetic Materials, 1998, Vol.185, p.283). Par le terme "discontinues", les auteurs font référence au fait que les couches de Co ou CoFe ne sont pas sous forme de couche mince d'épaisseur quasi-uniforme, mais plutôt sous la forme d'agrégats de Co ou CoFe enrobés dans la matrice d'oxyde. Ces systèmes sont préparés par pulvérisation cathodique en déposant alternativement les couches de métal magnétique et les couches d'oxydes. Les atomes de Co ou de CoFe tendent à coalescer sous la forme d'îlots disjoints, ce qui conduit à une structure en plan d'agrégats plus ou moins indépendants, suivant l'épaisseur de métal déposée, noyés dans la matrice isolante.

Dans ces structures, on ne conserve donc que le "souvenir" de cette couche mince de Co ou CoFe, ce qui est une situation complètement différente de celle considérée dans la présente invention. Dans ces études relatives aux multicouches discontinues métal/isolant, aucune mention n'est faite d'éventuelles propriétés d'anisotropie magnétique perpendiculaire de ces matériaux. Enfin, ces auteurs ne destinent pas non plus ces matériaux à une utilisation dans le domaine des capteurs de champ magnétique ou des mémoires ou composants logiques magnétiques basés notamment sur la mesure de l'Effet Hall Extraordinaire. Ces travaux ne relèvent donc pas non plus du champ d'application visé par la présente invention.

On peut aussi citer des travaux concernant des multicouches fabriquées par dépôt d'un alliage cobalt-fer suivi d'une oxydation naturelle de la surface de cet alliage en présence d'oxygène (voir G. S. D. Beach, A. E. Berkowitz, "Co-Fe metal/native-oxide multilayers: a new direction in soft magnetic thin film design I. Quasi-static properties and dynamic response", IEEE Transactions on Magnetics, 2005, Vol. 41, p 2043, et G. S. D. Beach, A. E. Berkowitz, "Co-Fe metal/native-oxide multilayers: a new direction in soft magnetic thin film design II. Microscopic characteristics and interactions", IEEE Transactions on Magnetics, 2005, Vol. 41, p 2053).

Ces multicouches présentent une forte résistivité électrique, un fort moment magnétique et une grande "douceur" magnétique (facilité à saturer l'aimantation dans une direction parallèle au plan des couches). Les auteurs ne mentionnent pas de propriété spéciale quant à l'amplitude de l'Effet Hall Extraordinaire. S'ils présentent des résultats semblant indiquer une tendance à l'apparition d'une certaine anisotropie perpendiculaire pour les faibles épaisseurs de métal magnétique, un examen plus précis des résultats montre que la réduction observée de l'amplitude du champ d'anisotropie perpendiculaire $H_K$ est essentiellement due à une diminution du terme $4\pi M_s$ (voir relation (5)), et non à une quelconque contribution d'un terme d'anisotropie perpendiculaire $H_S$.

De la même manière, les auteurs prédisent que l'aimantation est spontanément perpendiculaire au plan des couches pour des épaisseurs de métal magnétique inférieures à 1,1 nanomètre, alors que dans le même temps ils présentent des résultats pour une épaisseur de 1,0 nanomètre, donc inférieure à cette limite, qui montrent sans ambiguïté que l'aimantation est dans ce cas parallèle au plan des couches et non pas perpendiculaire.

On peut enfin citer des travaux concernant des empilements constitués de deux multicouches (Pt/Co) et Co/Pt) séparées par une couche d'oxyde NiO (voir C. Christides et Th. Speliotis, "*Polarity of anomalous Hall effect hysteresis loops in (Pt/Co)$_{15}$/AF/(Co/Pt)$_{15}$ (AF = FeMn, NiO) multilayers with perpendicular anisotropy*", Journal of Applied Physics, 2005, Vol. 97, p. 013901).

Dans ce document, il apparaît que les deux multicouches de part et d'autre de la couche de NiO auraient leur aimantation perpendiculaire au plan des couches en l'absence de la couche de NiO. Ceci ressort clairement de la comparaison de la figure 2 (présence de la couche de NiO) et de la figure 3 (absence de la couche de NiO), figures qui montrent que dans les deux cas l'aimantation des couches magnétiques est orientée perpendiculairement au plan des couches. En d'autres termes, ce n'est donc pas la présence de la couche séparatrice de NiO qui confère à cet empilement ses propriétés d'anisotropie magnétique perpendiculaire.

CN 1588539 A décrit une multicouche avec une alternance des couches ferromagnétiques et NiO.

## EXPOSE DE L'INVENTION

La présente invention propose un moyen de réalisation d'un dispositif magnétique en multicouches présentant un champ d'anisotropie hors du plan d'une valeur proche de son champ démagnétisant, de sorte que le dispositif possède une grande sensibilité au champ magnétique, laquelle peut être détectée par la mesure de l'Effet Hall Extraordinaire, ou encore la mesure de la magnétorésistance ou la mesure de l'Effet Kerr ou de l'Effet Faraday magnéto-optique. Le matériau utilisé permet de réunir les avantages des différents matériaux cités ci-dessus, à savoir une forte anisotropie perpendiculaire pouvant compenser ou même surpasser l'anisotropie de forme propre aux couches minces, et dans le cas particulier de la mesure de l'Effet Hall, une forte résistivité longitudinale et un fort coefficient de Hall extraordinaire.

Ainsi, l'invention vise un dispositif magnétique multicouches, comportant, sur un substrat, une alternance de couches métalliques magnétiques M et d'oxydes, d'hydrures ou de nitrures O, dans lequel, le nombre de couches M est au moins égal à deux, et dans lequel les couches M sont continues.

De plus, une anisotropie magnétique interfaciale perpendiculaire au plan des couches aux interfaces M/O et O/M existe pour une gamme de température égale ou supérieure à la température ambiante, apte à orienter l'aimantation des couches M sensiblement perpendiculairement au plan des couches.

La forte anisotropie magnétique perpendiculaire évoquée plus haut est obtenue, comme dans le cas des multicouches cobalt/platine, par des effets de contrainte et d'hybridation électronique aux interfaces entre les couches magnétiques et les couches d'oxydes, d'hydrures ou de nitrures. Comme dans le système (Co/Pt), les couches magnétiques doivent donc être minces (quelques nanomètres) afin que ces effets d'interfaces ne deviennent pas négligeables devant l'anisotropie magnétique volumique de forme, qui elle tend à maintenir l'aimantation de la couche magnétique dans le plan.

La forte résistivité longitudinale est obtenue par l'utilisation de couches magnétiques minces, donc de forte résistivité du fait du rôle important joué par les diffusions interfaciales, alternant avec des couches d'oxyde, de nitrure ou d'hydrure. L'ensemble de ces couches n'étant répété qu'un faible nombre de fois (typiquement moins de 20 répétitions) pour obtenir la structure multicouche finale, la résistance électrique de l'ensemble de l'empilement est donc élevée.

Selon l'invention, les couches métalliques magnétiques M présentent une épaisseur inférieure ou égale à 5 nanomètres et sont constituées d'un matériau magnétique, d'un alliage magnétique ou d'une multicouche formée de l'alternance de matériaux non magnétiques et magnétiques, ces derniers étant choisis dans le groupe constitué par Fe, Ni, Co ou leurs alliages. Les couches O d'oxydes, d'hydrures ou de nitrures présentent une épaisseur au moins égale à 0,3 nanomètre et sont réalisées à base d'éléments choisis dans le groupe comprenant Al, Mg, Ru, Ta, Cr, Zr, Hf, Ti, V, Si, Cu, W, Co, Ni, Fe, ou leurs alliages, et plus généralement de tout matériau ou alliage susceptible de former des oxydes, hydrures ou nitrures stables.

Avantageusement, le substrat recevant l'empilement précité est réalisé en silicium recouvert de silicium oxydé thermiquement ou naturellement sur une épaisseur comprise entre 2 et 500 nanomètres.

Cependant, ledit substrat peut être réalisé en un matériau transparent tel que par exemple du verre ou de l'oxyde de magnésium.

Selon une caractéristique avantageuse de l'invention, le dispositif comporte un matériau S servant d'initiateur de croissance pour la première couche métallique M, choisi dans le groupe comprenant le TiN, CuN, Pt, Ta, Ru, IrMn, PtMn, NiFeCr, les oxydes et les nitrures.

Selon une autre caractéristique avantageuse de l'invention, l'une au moins des couches métalliques M contient des additions de métaux non magnétiques Pd ou Pt, servant à modifier les propriétés d'anisotropie magnétique perpendiculaire de cette couche, ou d'éléments choisis dans le groupe comprenant Si, C, B, P, N, servant à modifier la résistivité électrique de cette couche et/ou son aimantation par unité de volume.

Selon l'invention, toutes les couches M sont réalisées en un même matériau magnétique, et toutes les couches O sont réalisées en un même matériau non magnétique. Cependant, la composition chimique d'au moins l'une des couches métalliques M peut être différente des autres. De même, la composition chimique d'au moins l'une des couches O peut être différente des autres.

En outre, toutes les couches O peuvent présenter la même épaisseur. Cependant, l'épaisseur d'au moins l'une des couches O peut être différente des autres.

De même, l'épaisseur d'au moins l'une des couches métalliques M peut être différente des autres.

Selon l'invention, au moins l'une des couches O peut elle-même être constituée d'une pluralité de couches réalisées en oxyde, en hydrure ou en nitrure.

Avantageusement :

- la couche S présente une épaisseur comprise entre 0 et 2 nanomètres,
- chaque couche métallique M présente une épaisseur comprise entre 0,3 et 5 nanomètres,
- chaque couche O présente une épaisseur comprise entre 0,3 et 5 nanomètres,
- le nombre d'alternances de couches M et O est compris entre 1,5 et 20.

Le dispositif magnétique de l'invention présente avantageusement des dimensions latérales inférieures à 1 micromètre.

L'invention concerne également un procédé de réalisation du dispositif magnétique en question. Ce procédé consiste :

- à déposer sur une surface électriquement isolante une première couche métallique magnétique M par pulvérisation cathodique,
- à déposer une première couche du métal constitutif de la couche O sur cette première couche M par pulvérisation cathodique,
- à oxyder, hydrurer ou nitrurer cette première couche O,
- à répéter les trois étapes précédentes ou la première d'entre elles seulement,
- à déposer un contact électrique.

Alternativement, les deuxième et troisième étapes peuvent n'en constituer qu'une seule, à savoir le dépôt direct, par pulvérisation radio-fréquence, de la couche O d'oxyde, d'hydrure ou de nitrure à partir d'une cible composée de l'oxyde, de l'hydrure ou du nitrure correspondant.

Avantageusement, le dépôt de la première couche métallique M est précédé d'une pré-étape, consistant à déposer sur le substrat une couche réalisée en un matériau S initiateur de croissance. Cette pré-étape est elle-même susceptible d'être précédée d'un dépôt sur le substrat d'une couche d'un matériau conducteur électrique.

Selon le procédé de l'invention, une couche conductrice de l'électricité est déposée sur le dispositif ; celui-ci est alors taillé sous forme d'un pilier à base carrée, rectangulaire, circulaire ou elliptique, avec des dimensions latérales de quelques centaines de nanomètres ou moins.

Selon l'invention, on mesure la magnétorésistance de l'empilement ainsi réalisé en faisant parcourir ce dernier par un courant perpendiculairement au plan des couches qui le constituent.

Selon une variante de l'invention, les couches O sont obtenues par oxydation, hydruration ou nitruration naturelle de la couche métallique
Selon une autre variante, les couches O sont obtenues par oxydation, hydruration ou nitruration par procédé plasma de la couche métallique.

Selon encore une autre variante de l'invention, les couches O sont obtenues par pulvérisation réactive en présence d'oxygène, d'hydrogène ou d'azote dans l'atmosphère de la chambre de dépôt.

Selon encore une autre variante de l'invention, les couches O sont obtenues par dépôt direct de l'oxyde, de l'hydrure ou du nitrure par pulvérisation cathodique radio-fréquence à partir d'un matériau-cible composite d'oxyde, d'hydrure ou de nitrure métallique.

Selon l'invention, le dépôt de certaines couches est réalisé à une température différente de la température ambiante. Par exemple, certaines couches d'oxydes, d'hydrures ou de nitrures peuvent avoir une meilleure qualité structurale si on les fait croître à température élevée (par exemple 200°C). Par ailleurs, le dépôt d'une couche peut en outre être suivi d'un traitement thermique à une température supérieure à ladite température de dépôt. Cela peut être le cas par exemple pour favoriser l'oxydation ou la nitruration d'une couche ou encore permettre la cristallisation d'une couche amorphe.

Par ailleurs, après réalisation des étapes de dépôt, on peut soumettre l'ensemble ainsi obtenu à un traitement thermique pendant un temps plus ou moins long, dans une atmosphère raréfiée, ou en présence d'un certain gaz ou mélange de différents gaz, tels que l'oxygène, l'hydrogène ou l'azote par exemple, afin de modifier la structure et/ou les propriétés de transport électrique et/ou les propriétés magnétiques du dispositif.

L'invention vise un capteur de champ magnétique constitué du dispositif magnétique multicouches de l'invention, ce dernier présentant un champ d'anisotropie perpendiculaire contrebalançant presque son champ démagnétisant.

L'invention vise également une mémoire magnétique constituée du dispositif magnétique multicouches en question, dans lequel les couches magnétiques ont leur aimantation perpendiculaire au plan des couches en l'absence de champ magnétique extérieur.

L'invention concerne également une porte logique magnétique constituée dudit dispositif magnétique multicouches, dans lequel les couches magnétiques ont leur aimantation perpendiculaire au plan des couches en l'absence de champ magnétique extérieur.

Afin de déterminer l'orientation des aimantations des couches magnétiques du dispositif magnétique qui les compose :

- on mesure l'Effet Hall Extraordinaire par injection d'un courant électrique dans une direction parallèle au plan des couches,
- ou on mesure la magnétorésistance par injection d'un courant électrique dans une direction perpendiculaire au plan des couches ;
- ou encore, on mesure l'Effet Kerr ou l'Effet Faraday magnéto-optique.

## BREVE DESCRIPTION DES DESSINS

La figure 1 est une représentation schématique d'un exemple de mode de mesure de l'Effet Hall Extraordinaire d'un échantillon magnétique.

La figure 2 est une représentation schématique d'une courbe d'aimantation caractéristique d'un dispositif magnétique de l'art antérieur.

La figure 3 est une représentation schématique de la variation typique de l'aimantation en fonction du champ magnétique pour un matériau à anisotropie magnétique perpendiculaire.

Ces trois premières figures ont déjà été décrites en relation avec l'état antérieur de la technique.

La figure 4 est une représentation schématique d'une première forme de réalisation du dispositif magnétique conforme à l'invention.

La figure 5 présente la variation de la résistance de Hall en fonction du champ magnétique perpendiculaire pour une structure du type Pt 0,3nm / (CoFe 0,6nm / $Al_2O_3$ 2,0nm)$_5$.

La figure 6 est une représentation schématique d'une deuxième forme de réalisation du dispositif magnétique conforme à l'invention.

La figure 7 représente la variation de la résistance de Hall en fonction du champ magnétique perpendiculaire pour une structure du type Pt 1,0nm / Co 0,6nm / $Al_2O_3$ 2,0nm / (CoFe 0,6nm / $Al_2O_3$ 2,0nm)$_5$.

La figure 8 est une représentation schématique d'une troisième forme de réalisation du dispositif magnétique conforme à l'invention.

La figure 9 présente la variation de la résistance de Hall en fonction du champ magnétique perpendiculaire pour une structure du type Pt 1,0nm / Co 0,6nm / $Al_2O_3$ 2,0nm / (CoFe 0,6nm / $Al_2O_3$ 2,0nm)$_5$. La pression d'oxygène est légèrement inférieure à celle utilisée dans le cas de la figure 7.

La figure 10 représente la variation de la résistance de Hall en fonction du champ magnétique perpendiculaire pour l'empilement décrit en relation avec les figures 8 et 9, après un traitement thermique de 30 minutes à 350°C.

La figure 11 est une représentation schématique d'une cinquième forme de réalisation du dispositif magnétique conforme à l'invention.

## DESCRIPTION DES MODES PARTICULIERS DE REALISATION DE L'INVENTION

Sans être limitatif, et à titre d'exemple, les matériaux et les techniques utilisés dans les modes de réalisation décrits ci après sont les suivants.

Sur un substrat, par exemple en silicium, en silicium oxydé, en verre ou en oxyde de magnésium, on dépose une première couche d'un métal non magnétique qui sert de couche tampon. Cette couche favorise l'adhérence et la bonne croissance du reste de la structure.

Bien qu'elle ne soit pas indispensable à l'invention, cette couche sera utilisée pour la description des modes de réalisation préférentielle. Les diverses couches seront décrites à partir de cette première couche en matériau non magnétique (ou à défaut de la première couche M), car c'est ce qui correspond à l'ordre de dépôt successif des couches lors de la fabrication.

La figure 4 est une représentation schématique d'une première forme de réalisation conforme à l'invention. Sur cette figure (et les figures suivantes 6, 8, et 11), la direction des flèches indique la direction, en l'absence de champ magnétique appliqué, de l'aimantation des couches magnétiques (flèche horizontale pour une aimantation planaire, flèche verticale pour une aimantation perpendiculaire).

Immédiatement après le substrat se trouve une couche de matériau initiateur de croissance, comme par exemple le platine. Il peut être remplacé par un autre matériau ou par la combinaison d'autres matériaux réputés convenir pour initier une bonne croissance de couches minces métalliques, notamment induisant une très faible rugosité de surface. On peut citer par exemple le nitrure de titane, le nitrure de cuivre, le ruthénium, le tantale, les alliages iridium-manganèse, platine-manganèse, nickel-fer-chrome, etc. Il est également possible de ne pas utiliser cette couche initiale, s'il s'avère que les qualités de croissance de la couche magnétique sur le substrat sont satisfaisantes.

Ensuite se trouve la première couche M, dont l'épaisseur est généralement faible. Si cette épaisseur dépasse une certaine valeur dépendant du matériau utilisé pour la couche M et de l'intensité des interactions interfaciales avec les matériaux au contact de cette couche magnétique M, l'aimantation n'est plus, de manière connue, perpendiculaire au plan de la couche du fait de l'anisotropie volumique de forme de cette couche M qui tend à maintenir l'aimantation de cette couche dans son plan.

Pour les couches M suivantes, le choix de leur épaisseur est surtout déterminé par la possibilité d'obtention d'une couche métallique continue. En effet, comme discuté précédemment, certains métaux magnétiques mouillent mal sur les oxydes tels que la silice ou l'alumine. Dans certains cas, le métal magnétique a tendance à coalescer sous la forme d'îlots plus ou moins disjoints suivant l'épaisseur du métal déposée.

Dans d'autres cas, les effets de tension superficielle sont trop faibles pour que le phénomène de coalescence en îlots ait lieu. La couche métallique peut alors être continue. La gamme d'épaisseurs permettant l'obtention de couche continue de métal dépend de l'énergie surfacique de l'oxyde, de l'énergie surfacique du métal et de l'énergie interfaciale de l'interface oxyde/métal, et de la mouillabilité de la surface de dépôt par la couche métallique d'apport. Cette gamme d'épaisseur possible pour l'obtention de couches métalliques continues dépend donc à la fois du métal M et de l'oxyde.

Pour un même matériau de base M, on peut modifier l'épaisseur critique de la couche magnétique par adjonction d'éléments d'addition, améliorant la mouillabilité en abaissant l'énergie de surface du métal à la faveur de l'énergie de l'interface oxyde/métal. Selon un mode habituel de réalisation, le matériau est un alliage magnétique $Co_{90}Fe_{10}$ d'épaisseur comprise entre 0,3 et 5 nanomètres, typiquement de 0,6 nanomètre.

Afin d'adapter les propriétés magnétiques du dispositif en fonction de l'application visée (capteur de champ, dispositif mémoire ou porte logique) et obtenir les meilleures performances notamment en terme d'anisotropie magnétique perpendiculaire et de croissance sur la couche d'oxyde sous-jacente, l'alliage $Co_{90}Fe_{10}$ peut être remplacé par un alliage $Co_xFe_y$ de concentration différente, ou par un alliage ternaire $Co_xNi_yFe_z$, ou par un alliage, cristallisé ou amorphe, d'un ou plusieurs de ces matériaux magnétiques avec un autre élément non magnétique, tel le bore, le silicium, le phosphore, et/ou le carbone. On peut également utiliser un alliage ou une multicouche composée d'un matériau magnétique et d'un matériau non magnétique.

On peut également modifier la nature et l'épaisseur des couches magnétiques au fur et à mesure de l'empilement des couches. La composition chimique et l'épaisseur de la première couche magnétique ne doit pas être forcément identique à la deuxième, qui elle-même ne doit pas être forcément identique à la énième dans le cas où la bicouche métal magnétique/oxyde est répétée n fois. Cette modification peut être avantageusement utilisée suivant le type de propriété que l'on désire favoriser, par exemple bonne croissance des couches magnétiques (planéité, texture) ou bonnes propriétés d'anisotropie perpendiculaire.

Après la première couche M se trouve la première couche O, préférentiellement en oxyde d'aluminium, dont l'épaisseur est de l'ordre de 0,3 à 5 nanomètres, ce dernier chiffre n'étant pas très critique. Cette couche est généralement constituée d'un dépôt de métal, comme par exemple l'aluminium, qui a été oxydé. Mais l'aluminium peut être remplacé par tout autre élément susceptible de former avec l'oxygène des oxydes en couches minces de bonne qualité, à savoir par exemple le magnésium, le ruthénium, le silicium, le tantale, le chrome, le zirconium, le titane, l'hafnium, le vanadium, le cobalt, le nickel, le fer, le cuivre, le tungstène, et plus généralement de tout matériau ou alliage susceptible de former des oxydes stables.

On peut également utiliser pour certaines réalisations particulières, un alliage ou une multicouche de ces matériaux en tant que couche d'oxyde élémentaire. La nature et l'épaisseur des couches d'oxyde peuvent également être modifiées au fur et à mesure de l'empilement des couches. Pour les mêmes raisons que celles évoquées ci-dessus, la composition chimique et l'épaisseur de la première couche d'oxyde ne doivent pas être forcément identiques à celles de la deuxième, qui elle-même ne doit pas être forcément identique à la énième dans le cas où la bicouche métal magnétique/oxyde est répétée n fois.

Cette couche d'oxyde peut également se substituer à la couche initiatrice de croissance (couche tampon) mentionnée plus haut.

Il est également possible de réaliser l'oxyde, non pas par une technique d'oxydation plasma, mais par une technique connue de pulvérisation réactive de l'élément considéré en présence d'une certaine quantité d'oxygène dans l'atmosphère de la chambre de dépôt, ou par une méthode d'oxydation naturelle, ou encore en déposant directement l'oxyde par pulvérisation radio-fréquence d'un matériau-cible composite MOx, où M désigne un des métaux cités plus haut et Ox l'oxygène.

Des résultats analogues peuvent être obtenus en effectuant une nitruration ou une hydruration et non pas une oxydation.

Afin de modifier les qualités de croissance des différentes couches, il peut aussi être intéressant de déposer les couches successives, ou certaines d'entre elles, sur un substrat maintenu à une température différente de la température ambiante.

L'ensemble constitué par la couche M et la couche O peut se répéter jusqu'à ce qu'il y ait environ 20 couches O, et de manière optionnelle peut comporter une dernière couche M afin de terminer le dispositif multicouche par une couche M, notamment dans le cas où l'on souhaite utiliser le dispositif magnétique selon l'invention pour des applications du type mémoires magnétiques ou portes logiques magnétiques. Typiquement, le couple de couches M puis O se répète par exemple 5 fois.

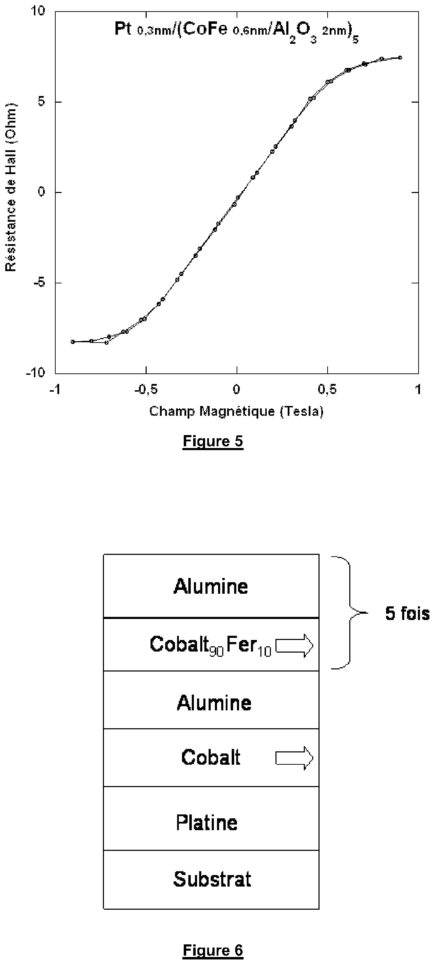

La figure 5 présente la variation de la résistance de Hall en fonction du champ magnétique pour une structure du type Pt 0,3nm / (CoFe 0,6nm / Al$_2$O$_3$ 2,0nm)$_5$. Le champ magnétique est appliqué selon une direction perpendiculaire au plan des couches. Cette structure est donc composée de cinq répétitions d'une bicouche (CoFe/Al$_2$O$_3$) déposées sur une couche de croissance de platine d'une épaisseur de 0,3 nanomètre.

La résistivité longitudinale de cet empilement est de l'ordre de 1000 $\mu\Omega$cm, soit presque deux ordres de grandeur supérieurs à un empilement similaire métallique (i.e. dans lequel on aurait remplacé par exemple les couches d'oxyde par des couches de platine d'épaisseur équivalente). La résistance de Hall varie de façon linéaire et réversible sur une gamme de champ magnétique de +/- 0,4 T (Tesla), et la sensibilité au champ correspondante est de l'ordre de 14 $\Omega$/T.

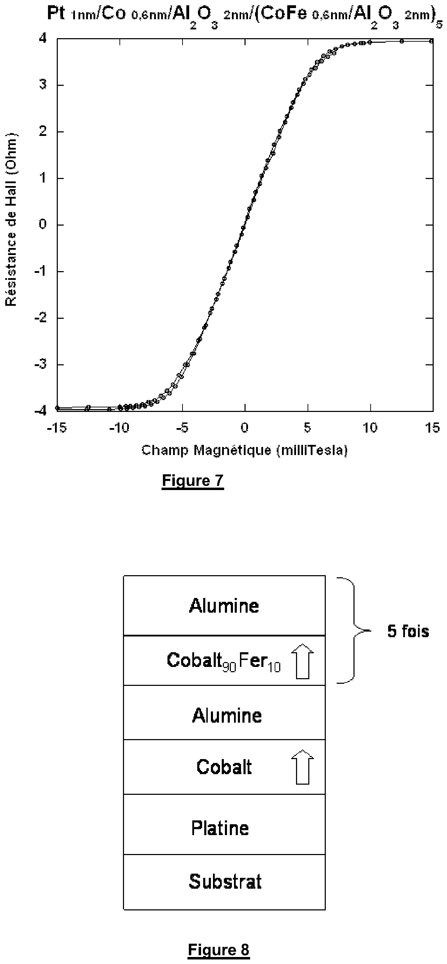

La figure 6 est une représentation schématique d'une deuxième forme de réalisation conforme à l'invention. La figure 7 présente la variation de la résistance de Hall en fonction du champ magnétique pour une structure du type Pt 1,0nm / Co 0,6nm / Al$_2$O$_3$ 2,0nm / (CoFe 0,6nm / Al$_2$O$_3$ 2,0nm)$_5$, c'est-à-dire une bicouche (Co/Al$_2$O$_3$) déposée sur une couche de croissance de platine d'une épaisseur de 1 nanomètre et surmontée de cinq bicouches (CoFe/Al$_2$O$_3$).

Comme dans le cas précédent, la résistivité longitudinale de cet empilement est également de l'ordre de 1000 $\mu\Omega$cm. La résistance de Hall est plus faible que dans le cas précédent (de l'ordre de 4 $\Omega$ à la saturation au lieu de 8 $\Omega$), à cause d'une part du plus grand nombre de répétitions de l'empilement (6 au total au lieu de 5) et de l'effet négatif de la couche initiale de platine plus épaisse (1,0 nanomètre au lieu de 0,3 nanomètre) qui dérive une partie du courant circulant dans la structure.

Par contre, cette couche de platine légèrement plus épaisse renforce considérablement les propriétés d'anisotropie magnétique perpendiculaire. Le champ d'anisotropie perpendiculaire n'est en effet que de 6 mT (milliTesla), soit cent fois plus faible que dans le cas de la figure 5, et trois cent fois plus faible que la valeur du terme de champ démagnétisant $4\pi M_s$, où $M_s$ est l'aimantation de l'alliage Co$_{90}$Fe$_{10}$.

On obtient dans ce cas une sensibilité au champ magnétique de l'ordre de 700 $\Omega$/T, soit 50 fois plus forte que dans le cas précédent. Cette valeur est très largement supérieure aux valeurs mentionnées dans l'état antérieur de la technique, ainsi qu'à celles obtenues avec des capteurs classiques semi-conducteurs, ce qui rend les réalisations selon ce mode particulièrement adaptée à leur utilisation en tant que capteurs de champ magnétique.

On peut également remarquer que cette sensibilité au champ magnétique peut, en modifiant la structure de l'empilement, et donc les propriétés d'anisotropie magnétique perpendiculaire, être ajustée à volonté. Dans des conditions particulières (par exemple par une oxydation plus ou moins importante de la couche séparatrice non magnétique), la contribution d'anisotropie magnétique perpendiculaire peut devenir tellement élevée que l'aimantation de l'empilement est alors spontanément (sans champ magnétique appliqué) dirigée dans une direction perpendiculaire au plan des couches.

C'est le cas qui est illustré dans une troisième forme de réalisation de l'invention schématisée à la figure 8, avec un empilement identique à celui présenté à la figure 6, mais pour lequel les conditions d'oxydation ont été légèrement modifiées (pression d'oxygène légèrement inférieure pendant l'oxydation plasma de la couche d'aluminium), avec pour conséquence de stabiliser la direction de l'aimantation des couches perpendiculairement au plan desdites couches en l'absence de champ magnétique appliqué. Ce type de structure est donc tout à fait adapté à la réalisation de mémoires magnétiques ou de portes logiques magnétiques.

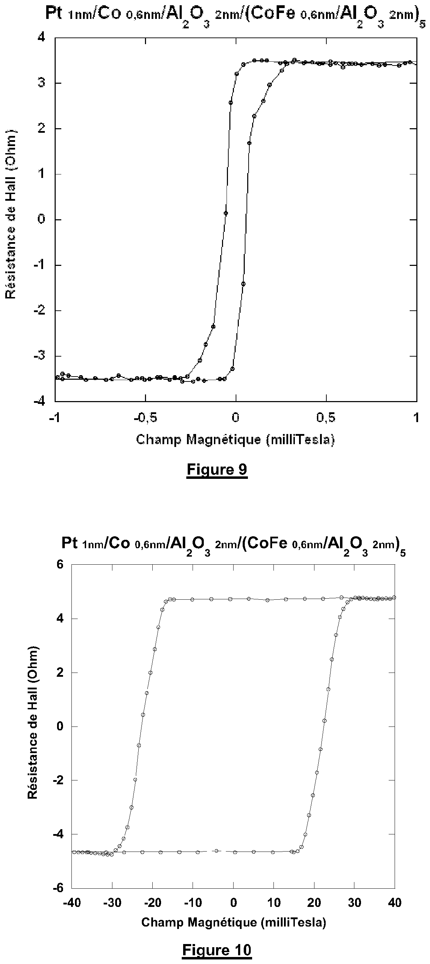

Comme on peut le voir sur la figure 9, on obtient dans ce cas deux états stables en champ magnétique nul, soit une résistance de Hall de +/- 3,5 $\Omega$ suivant que l'on vient des champs magnétiques positifs ou négatifs. L'inversion de résistance se produit pour des champs magnétiques très faibles, de l'ordre de 0,3 mT dans le cas présent.

Il faut à nouveau rappeler que ce paramètre (le champ coercitif, ainsi que défini en relation avec la figure 3) peut lui aussi être ajusté, soit en modifiant la composition de l'empilement (épaisseurs de couches, nature du matériau ferromagnétique, nombre de répétitions du motif métal magnétique/oxyde), soit en utilisant une technique ou des conditions d'oxydation différentes (pression d'oxygène, temps d'oxydation, puissance plasma, etc.) soit en effectuant des traitements thermiques post-dépôt.

C'est l'effet de ce dernier paramètre qui est illustré dans une quatrième forme de réalisation. Dans ce cas, l'empilement représenté à la figure 8 et dont la courbe d'aimantation avant tout traitement thermique est présentée à la figure 9, a été, après dépôt, maintenu à une température de 350°C pendant un temps de 30 minutes dans une atmosphère raréfiée de $10^{-6}$ mbar, puis refroidi jusqu'à la température ambiante, où ses propriétés magnétiques ont à nouveau été mesurées.

La figure 10 illustre la variation de la résistance de Hall en fonction du champ magnétique appliqué perpendiculairement au plan des couches. Deux différences essentielles apparaissent par rapport à la figure 9 qui représentait la mesure de la même propriété sur l'empilement n'ayant pas subi de traitement thermique.

Tout d'abord, on constate une importante augmentation de l'amplitude de la résistance de Hall, qui est maintenant de +/- 4,7 $\Omega$ après traitement thermique, soit une augmentation de 35% par rapport à la valeur initiale. De plus, le champ coercitif s'est considérablement modifié, puisqu'il passe de 0,3 mT à 22 mT après traitement thermique, soit une augmentation de près de deux ordres de grandeur.

Il est donc tout à fait possible, par traitement thermique, de modifier à volonté les propriétés magnétiques de ce type de matériau, afin de maximiser la résistance de Hall et d'ajuster en fonction de l'application visée la stabilité de l'aimantation par rapport au champ magnétique extérieur (c'est-à-dire son champ coercitif). Ces traitements thermiques ont de plus l'avantage de rendre le dispositif beaucoup plus stable en terme structural par rapport à d'éventuelles variations de température.

Dans cette forme de réalisation, l'état magnétique du dispositif peut être déterminé soit par mesure d'Effet Hall, soit encore par une mesure magnéto-optique.

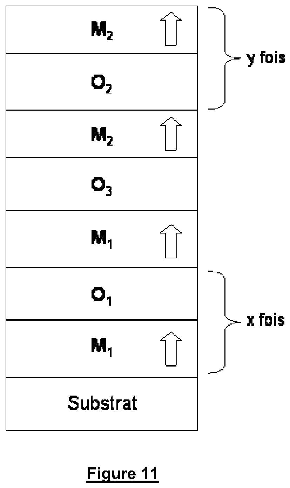

Dans une cinquième forme de réalisation, en relation avec la représentation schématique de la figure 11, il est possible de superposer deux blocs élémentaires du type $(M_1/O_1)_x/M1$ et $M_2/(O_2/M_2)_y$, où M désigne un matériau magnétique et O une couche d'oxyde, d'hydrure ou de nitrure, séparés par une troisième couche $O_3$, et où x et y sont des nombres entiers positifs ou nuls.

La composition et l'épaisseur des couches formant chacun de ces deux blocs, ainsi que les nombres respectifs x et y de répétitions des deux motifs élémentaires $(M_1/O_1)$ et $(O_2/M_2)$ sont choisis pour que chacun des deux blocs présente spontanément (en champ magnétique nul) une aimantation perpendiculaire au plan des couches. Ces nombres de répétitions x et y peuvent varier typiquement de 0 à 20.

Si le nombre, la nature et l'épaisseur des couches $M_1$, $M_2$, $O_1$ et $O_2$ constitutives de chacun des deux blocs, ainsi que l'épaisseur et la nature de la couche $O_3$, sont bien choisis, les duretés magnétiques (les champs coercitifs) de ces deux blocs peuvent être différentes. Dans ce cas, une séquence particulière de champs magnétiques appliqués permettra d'atteindre les quatre états magnétiques de l'empilement, pour lesquels les aimantations des deux blocs sont parallèles (toutes deux vers le haut ou vers le bas, en supposant que les couches sont empilées dans un plan horizontal), ou antiparallèles (une vers le haut et une vers le bas). Cette description peut également être généralisée à un nombre de blocs magnétiques supérieur à deux.

Dans cette forme de réalisation, chacun des quatre états magnétiques correspond à une résistance de Hall différente. La mesure de la tension de Hall correspondante, ou de l'aimantation, ou de la rotation ou de l'ellipticité Kerr ou Faraday, ou de la magnétorésistance, permet donc d'identifier l'état magnétique du dispositif. Cette forme de réalisation est donc adaptée à la réalisation de dispositifs du type supports d'enregistrement magnétique multiniveaux.

Dans une variante de cette forme de réalisation, l'empilement ainsi réalisé, et taillé sous forme d'un pilier à base carrée, rectangulaire, circulaire ou elliptique, avec des dimensions latérales de quelques centaines de nanomètres ou moins, peut être parcouru par un courant électrique dans une direction perpendiculaire au plan des couches. Par le phénomène bien connu dans la littérature et dit de "magnétorésistance tunnel", les orientations parallèle et antiparallèle des aimantations des deux blocs correspondront respectivement à des états de basse et haute résistance électrique. Des prises de tension connectées en bas et en haut de l'empilement permettront de détecter cette différence de résistance électrique.

Cette forme de réalisation, illustrative d'une structure de type jonction tunnel magnétique, est donc adaptée à la réalisation de dispositifs tels que des mémoires magnétiques non volatiles ou des portes logiques magnétiques.

Pour certaines ou toutes les formes de réalisation ci-dessus décrites, il est possible de mettre au contact d'une ou plusieurs des couches M considérées une couche d'un matériau, tel les alliages IrMn, PtMn, FeMn ou NiMn, réputés pour induire un couplage d'échange antiferromagnétique avec ladite ou lesdites couches M.

L'invention concerne également le procédé de fabrication de dispositifs conformes aux descriptions précédentes. Ce procédé est défini comme suit, sans que cette présentation ne soit en aucun cas exhaustive.

Les différentes couches des empilements présentés ici sont déposées par pulvérisation cathodique avec des vitesses de dépôt de l'ordre de 0,1 nm/s, sur des substrats de silicium recouverts de 500 nanomètres de silicium oxydé thermiquement.

Les couches d'oxyde, d'hydrure ou de nitrure sont réalisées en déposant tout d'abord la couche du matériau correspondant, puis en effectuant une oxydation, hydruration ou nitruration plasma de cette couche avec des puissances de l'ordre de 10 W sous une pression de 3 x $10^{-3}$ mbar d'oxygène, d'hydrogène ou d'azote pendant une durée de quelques minutes.

Tout d'abord, on dépose sur le substrat une fine couche de matériau non magnétique. Cette couche initiale a pour but de permettre une bonne croissance des couches suivantes. Il faut qu'elle soit la plus mince possible, afin qu'elle court-circuite le moins possible le courant injecté dans la structure lorsqu'on désire mesurer l'aimantation de l'empilement par Effet Hall.

On dépose ensuite une couche d'alliage magnétique $Co_{90}Fe_{10}$, d'une épaisseur également très faible. Il est connu dans la littérature que, dans le cas des multicouches cobalt/platine par exemple, les meilleures propriétés d'anisotropie magnétique perpendiculaire sont obtenues pour des épaisseurs de couches magnétiques comprises entre 0,3 et 1,0 nanomètre. Dans les exemples décrits ci après, l'épaisseur de la couche de $Co_{90}Fe_{10}$ a été fixée à 0,6 nanomètre. Le choix d'une épaisseur aussi faible permet également, comme mentionné *supra*, d'augmenter fortement la résistivité de cette couche comparée à celle d'une couche plus épaisse.

Inversement, trop diminuer cette épaisseur pourrait, soit diminuer l'aimantation intrinsèque de cette couche, soit fortement diminuer sa température d'ordre magnétique. Dans les deux cas, ceci conduirait à une diminution de l'aimantation effective de cette couche à la température d'utilisation du dispositif, à savoir à proximité de la température ambiante. Selon la relation (1), ceci conduirait à une diminution de la résistivité de Hall, et donc à une diminution du signal de sortie du dispositif. Pour d'autres types d'applications décrites dans la présente invention, on pourra augmenter cette épaisseur de la couche magnétique jusqu'à 5 nanomètres.

Enfin, on dépose une couche, d'aluminium par exemple, d'une épaisseur de l'ordre de 0,3 à 5 nanomètres. L'échantillon est ensuite soumis à un plasma, d'oxygène par exemple, dans des conditions de pression, puissance et temps bien définies. Ceci permet de transformer cet aluminium métallique en oxyde d'aluminium.

Il est évident que, cette couche d'alumine étant isolante électriquement, son épaisseur est beaucoup moins critique que celle des couches précédentes. Ceci est en revanche différent si l'oxyde (ou l'hydrure ou le nitrure) du métal considéré est conducteur électrique. Dans le cas d'une couche isolante, ce qui fixe son épaisseur dépend à la fois des propriétés de croissance de cette couche, dont la rugosité peut s'amplifier avec l'épaisseur et donc avoir un effet néfaste sur la qualité de croissance des couches suivantes, et des mécanismes d'oxydation qui peuvent éventuellement se modifier en fonction de l'épaisseur totale. Les exemples suivants concernent une épaisseur d'aluminium de 1,6 nanomètre, correspondant approximativement à 2 nanomètres d'alumine après oxydation de cette couche métallique.

Cette bicouche métal magnétique / oxyde, ou métal magnétique / hydrure, ou métal magnétique / nitrure, peut éventuellement être répétée un certain nombre de fois. Qualitativement, augmenter le nombre de répétitions permet de diminuer la contribution relative de la couche initiatrice de croissance dans les mesures de transport électrique (proportionnellement moins de courant dérivé dans cette couche), mais par contre entraîne, de manière connue, une diminution de l'anisotropie magnétique perpendiculaire de l'ensemble de l'empilement.

Dans le cas d'une seule répétition, on peut également terminer la partie "active" de l'empilement par une seconde couche magnétique, éventuellement différente de la première en composition et en épaisseur.

Enfin, il est possible de réaliser des traitements thermiques pendant ou après le dépôt de l'empilement. Par traitement thermique, on entend le fait de soumettre le matériau ainsi préparé à une température plus élevée que la température à laquelle il a été déposé, pendant un temps plus ou moins long, dans une atmosphère raréfiée ou en présence éventuelle d'un certain gaz ou mélange de différents gaz, tels que oxygène, hydrogène ou azote par exemple.

Ces traitements ont pour but d'augmenter la résistivité longitudinale de l'empilement, par disruption éventuelle de la couche magnétique et/ou formation d'un alliage aux interfaces. Ils peuvent également modifier la structure chimique ou cristallographique des couches, et en conséquence modifier les propriétés magnétiques de l'empilement ainsi réalisé.

**Revendications**

**1.** Dispositif magnétique multicouches, comportant, sur un substrat, une alternance de couches métalliques magnétiques M et d'oxydes, d'hydrures ou de nitrures O, *caractérisé* :

- en ce que le nombre de couches M est au moins égal à deux,
- en ce que les couches d'oxydes, d'hydrures ou de nitrures O présentent une épaisseur au moins égale à 0,3 nanomètre et sont réalisées à base d'éléments choisis dans le groupe comprenant Al, Mg, Ru, Ta, Cr, Hf, Ti, V, Si, Cu, W ou leurs alliages, de telle sorte à former des oxydes, hydrures ou nitrures stables,
- en ce que les couches M sont continues, présentent une épaisseur inférieure ou égale à 5 nanomètres, et auraient leur aimantation parallèle au plan des couches en l'absence des couches O,
- et en ce qu'il existe, pour une gamme de température égale ou supérieure à la température ambiante, une anisotropie magnétique interfaciale perpendiculaire au plan des couches aux interfaces M/O et O/M, apte à orienter l'aimantation des couches M sensiblement perpendiculairement au plan des couches.

**2.** Dispositif magnétique multicouches selon la revendication 1, *caractérisé* **en ce que** les couches métalliques magnétiques M sont constituées d'un matériau magnétique, d'un alliage magnétique ou d'une multicouche formée de l'alternance de matériaux non magnétiques et magnétiques, ces derniers étant choisis dans le groupe constitué par Fe, Ni, Co ou leurs alliages.

3. Dispositif magnétique multicouches selon l'une des revendications 1 et 2, *caractérisé* **en ce qu'**il comporte un matériau S servant d'initiateur de croissance pour la première couche métallique M, ce matériau S étant choisi dans le groupe comprenant le TiN, CuN, Pt, Ta, Ru, IrMn, PtMn, NiFeCr, les oxydes et les nitrures.

4. Dispositif magnétique multicouches selon l'une des revendications 1 à 3, *caractérisé* **en ce qu'**au moins l'une des couches M contient des additions de métaux non magnétiques Pd ou Pt, ou d'éléments choisis dans le groupe comprenant Si, C, B, P.

5. Dispositif magnétique multicouches selon l'une des revendications 1 et 2, *caractérisé* **en ce que** toutes les couches M sont réalisées en un même matériau magnétique, et toutes les couches O sont réalisées en un même matériau non magnétique.

6. Dispositif magnétique multicouches selon l'une des revendications 3 à 5, *caractérisé* :

   - en ce que chaque couche métallique M présente une épaisseur comprise entre 0,3 et 5 nanomètres,
   - en ce que chaque couche O présente une épaisseur comprise entre 0,3 et 5 nanomètres,
   - et en ce que le nombre d'alternances de couches M et O est compris entre 1,5 et 20, soit de structure générique M/O/M à $(M/O)_{20}$.

7. Dispositif magnétique multicouches selon la revendication 6, *caractérisé* **en ce que** la composition chimique d'au moins l'une des couches magnétiques M est différente des autres.

8. Dispositif magnétique multicouches selon l'une quelconque des revendications 1 à 7, *caractérisé* **en ce qu'**au moins l'une des couches O est elle-même constituée d'une pluralité de couches réalisée en oxyde, en hydrure ou en nitrure.

9. Dispositif magnétique multicouches selon l'une quelconque des revendications 1 à 8, *caractérisé* **en ce que** l'une ou plusieurs des couches M est en contact avec un matériau réputé pour induire un couplage d'échange avec ladite couche M, et notamment FeMn, IrMn, PtMn, NiMn.

10. Procédé de réalisation d'un dispositif magnétique multicouches selon l'une quelconque des revendications 1 à 9, *caractérisé* **en ce qu'**il comprend les étapes suivantes :

    - dépôt sur une surface électriquement isolante d'une première couche métallique magnétique M par pulvérisation cathodique,
    - réalisation de la première couche O sur cette première couche M,
    - répétition des deux étapes précédentes ou de la seule première de celles-ci,
    - dépôt d'un contact électrique.

11. Procédé de réalisation d'un dispositif magnétique multicouches selon la revendication 10, *caractérisé* :

    - **en ce que** l'étape de dépôt de la première couche métallique M est précédée d'une pré-étape, consistant à déposer sur le substrat une couche réalisée en un matériau initiateur de croissance ;
    - et **en ce que** ce matériau initiateur de croissance a une épaisseur suffisamment faible pour minimiser la quantité de courant dérivée dans cette couche par rapport au courant circulant dans la partie active du dispositif magnétique, lorsque ledit courant est injecté parallèlement au plan des couches.

12. Procédé de réalisation d'un dispositif magnétique multicouches selon la revendication 11, *caractérisé* **en ce que** ladite pré-étape est elle-même précédée d'un dépôt sur le substrat d'une couche d'un matériau conducteur électrique, servant à injecter un courant électrique dans une direction perpendiculaire au plan des couches.

13. Capteur de champ magnétique *caractérisé* **en ce qu'**il est constitué d'un dispositif magnétique multicouches selon l'une quelconque des revendications 1 à 9, présentant un champ d'anisotropie perpendiculaire contrebalançant presque son champ démagnétisant.

14. Mémoire magnétique *caractérisée* **en ce qu'**elle est constituée d'un dispositif magnétique multicouches selon l'une quelconque des revendications 1 à 9, dans lequel les couches magnétiques ont leur aimantation perpendiculaire au plan des couches en l'absence de champ magnétique extérieur.

15. Porte logique magnétique *caractérisée* **en ce qu'**elle est constituée d'un dispositif magnétique multicouches selon l'une quelconque des revendications 1 à 9, dans lequel les couches magnétiques ont leur aimantation perpendiculaire au plan des couches en l'absence de champ magnétique extérieur.

**Patentansprüche**

1. Mehrschichtige magnetische Vorrichtung, die auf einem Substrat abwechselnd magnetische Metallschichten M und Oxid-, Hydrid oder Nitridschichten O umfasst **dadurch gekennzeichnet, dass**:

   - die Zahl der Schichten M mindestens gleich zwei ist,
   - dass die Oxid-, Hydrid- oder Nitridschichten O eine Dicke von mindestens gleich 0,3 Nanometer haben und auf Basis von Elementen, ausgewählt aus der Gruppe bestehend aus Al, Mg, Ru, Ta, Cr, Hf, Ti, V, Si, Cu, W oder ihren Legierungen hergestellt werden, so dass stabile Oxide, Hydride oder Nitride gebildet werden,
   - dass die M-Schichten kontinuierlich sind, eine Dicke von kleiner oder gleich 5 Nanometern haben und ihre Magnetisierung parallel zur Schichtebene in Abwesenheit der O-Schichten verläuft,
   - und dass es in einem Temperaturbereich, gleich oder höher als Raumtemperatur, eine Grenzflächen Magnetische Grenzflächenanisotropie gibt, senkrecht zur Schichtebene an den Grenzflächen M/O und O/M, die die Magnetisierung der M-Schichten im Wesentlichen senkrecht zur Schichtebene ausrichten kann.

2. Mehrschichtige magnetische Vorrichtung, nach Anspruch 1, **dadurch gekennzeichnet, dass** die magnetischen Metallschichten aus einem magnetischen Material, einer magnetischen Legierung oder einem Verbund, gebildet aus abwechselnd nicht magnetische und magnetische Materialien bestehen, wobei letztere ausgewählt werden aus der Gruppe bestehend aus Fe, Ni, Co oder ihren Legierungen.

3. Mehrschichtige magnetische Vorrichtung, nach einem der Ansprüche 1 bis 2 **dadurch gekennzeichnet, dass** sie ein Material S enthält, das als Wachstumsinitiator für die erste Metallschicht M dient, dieses Material S wird ausgewählt aus der Gruppe bestehend aus TiN, CuN, Pt, Ta, Ru, IrMn, PtMn, NiFeCr, den Oxiden und den Nitriden.

4. Mehrschichtige magnetische Vorrichtung, nach einem der Ansprüche 1 bis 3 **dadurch gekennzeichnet, dass** mindestens eine der M-Schichten Zusätze nicht magnetischer Metalle Pd oder Pt oder von Elementen, ausgewählt aus der Gruppe zu der Si, C, B, P gehören, enthält.

5. Mehrschichtige magnetische Vorrichtung, nach einem der Ansprüche 1 bis 2 **dadurch gekennzeichnet, dass** alle M-Schichten aus demselben magnetischen Material ausgeführt werden und alle O-Schichten aus demselben nichtmagnetischen Material.

6. Mehrschichtige magnetische Vorrichtung, nach einem der Ansprüche 3 bis 5 **dadurch gekennzeichnet, dass**:

   - jede M- Metallschicht eine Dicke zwischen 0,3 und 5 Nanometern aufweist,
   - jede O-Schicht eine Dicke zwischen 0,3 und 5 Nanometern aufweist,
   - und dadurch, dass die Zahl der abwechselnden Schichten M und O zwischen 1,5 und 20 liegt, also die generische Struktur M/O/M bis $(M/O)_{20}$ hat.

7. Mehrschichtige magnetische Vorrichtung nach Anspruch 6, **dadurch gekennzeichnet, dass** die chemische Zusammensetzung mindestens einer der magnetischen Schichten M sich von den anderen unterscheidet.

8. Mehrschichtige magnetische Vorrichtung nach irgendeinem der Ansprüche 1 bis 7 **dadurch gekennzeichnet, dass** mindestens eine der O-Schichten selbst aus mehreren Schichten besteht, die aus Oxid, Hydrid oder Nitrid ausgeführt sind.

9. Mehrschichtige magnetische Vorrichtung nach irgendeinem der vorstehenden Ansprüche 1 bis 8, **dadurch gekennzeichnet, dass** eine oder mehrere der M-Schichten Kontakt mit einem Material hat, dass dafür bekannt ist, eine Austauschkopplung mit dieser Schicht M zu induzieren, und insbesondere FeMn, IrMn, PtMn, NiMn.

**10.** Verfahren zur Herstellung einer mehrschichtigen magnetischen Vorrichtung nach irgendeinem der vorstehenden Ansprüche 1 bis 9, **dadurch gekennzeichnet, dass** es die folgenden Schritte umfasst:

- Ablagerung auf einer elektrisch isolierenden Schicht einer ersten magnetischen Metallschicht M durch Kathodenzerstäubung,
- Ausführung der ersten Schicht O auf dieser ersten Schicht M,
- Wiederholung der beiden vorangehenden Schritte oder nur des ersten,
- Ablagerung eines elektrischen Kontakts.

**11.** Verfahren zur Herstellung einer mehrschichtigen magnetischen Vorrichtung nach Anspruch 10, **dadurch gekennzeichnet, dass**:

- vor dem Schritt der Ablagerung der ersten magnetischen Metallschicht M ein vorangehender Schritt stattfindet, der darin besteht auf dem Substrat eine Schicht abzulagern, die aus einem wachstumsinitiierenden Material ausgeführt wird;
- und dass das wachstumsinitiierende Material eine Dicke hat, die ausreichend klein ist, um die Menge des Nebenschlussstroms, bezogen auf den im aktiven Teil der Magnetvorrichtung zirkulierenden Strom, in dieser Schicht zu minimieren, wenn dieser Strom parallel zur Schichtebene eingespeist wird.

**12.** Verfahren zur Herstellung einer mehrschichtigen magnetischen Vorrichtung nach Anspruch 11, **dadurch gekennzeichnet, dass** diesem vorangehenden Schritt wiederum das Ablagern eines elektrisch leitenden Materials auf dem Substrat vorangeht, die dazu dient, einen elektrischen Strom in einer Richtung senkrecht zur Schichtebene einzuspeisen.

**13.** Magnetfeldsensor, **dadurch gekennzeichnet, dass** er aus einer mehrschichtigen magnetischen Vorrichtung nach irgendeinem der vorstehenden Ansprüche 1 bis 9 besteht, der ein senkrechtes magnetisches Anisotropiefeld aufweist, das das entmagnetisierende Feld fast ausgleicht.

**14.** Magnetisches Speicherelement, **dadurch gekennzeichnet, dass** es aus einer mehrschichtigen magnetischen Vorrichtung nach irgendeinem der vorstehenden Ansprüche 1 bis 9 besteht, bei dem die Magnetisierung der magnetischen Schichten senkrecht zur Schichtebene liegt, bei Abwesenheit eines äußeren Magnetfeldes.

**15.** Magnetisches Logikgatter, **dadurch gekennzeichnet, dass** es aus einer mehrschichtigen magnetischen Vorrichtung nach irgendeinem der vorstehenden Ansprüche 1 bis 9 besteht, bei dem die Magnetisierung der magnetischen Schichten senkrecht zur Schichtebene liegt, bei Abwesenheit eines äußeren Magnetfeldes.

**Claims**

**1.** A magnetic multilayer device comprising, on a substrate, an alternating sequence of magnetic metallic layers M and oxide, hydride or nitride layers O, wherein:

- the number of layers M equals at least two,
- the oxide, hydride or nitride layers O have a thickness of at least 0.3 nanometers and are based on elements selected from the group comprising Al, Mg, Ru, Ta, Cr, Hf, Ti, V, Si, Cu, W, or alloys thereof capable of forming stable oxides, hydrides or nitrides ;
- the layers M are continuous, have a thickness equal to or less than 5 nanometers, and would have their magnetization parallel to the plane of the layer in the absence of layers O,
- and, in a temperature range equal to or larger than ambient temperature, there occurs interfacial magnetic anisotropy perpendicular to the plane of the layers at the M/O and O/M interfaces, able to orient the magnetization of layers M in a direction substantially perpendicular to the plane of the layers.

**2.** A magnetic multilayer device as claimed in claim 1, wherein the magnetic metallic layers M consist of a magnetic element, a magnetic alloy or a multilayer formed by an alternating sequence of non-magnetic and magnetic materials, the latter being selected from the group comprising Fe, Ni, Co or alloys thereof.

**3.** A magnetic multilayer device as claimed in claim 1 or 2, wherein it comprises a material S that is used as a growth initiator for the first metallic layer M, this material S being selected from the group comprising TiN, CuN, Pt, Ta, Ru, IrMn, PtMn, NiFeCr, oxides and nitrides.

4. A magnetic multilayer device as claimed in anyone of claims 1 to 3, wherein at least one of layers M contains added non-magnetic metals Pd or Pt or elements selected from the group comprising Si, C, B, P.

5. A magnetic multilayer device as claim in claim 1 or 2, wherein all the layers M are made of the same magnetic material and all the layers O are made of the same non-magnetic material.

6. A magnetic multilayer device as claimed in anyone of claims 3 to 5, wherein :

   - each metallic layer M has a thickness of 0.3 to 5 nanometers,
   - each layer O has a thickness of 0.3 to 5 nanometers, and,
   - the number of alternating sequences of layers M and layers O is 1.5 to 20, thus constituting a generic structure from M/O/M to $(M/O)_{20}$.

7. A magnetic multilayer device as claimed in claim 6, wherein the chemical composition of at least one of magnetic layers M is different from the others.

8. A magnetic multilayer device as claimed in anyone of claims 1 to 7, wherein at least one of layers O itself consists of a plurality of layers made of oxide, hydride or nitride.

9. A magnetic multilayer device as claimed in anyone of claims 1 to 8, wherein one or several M layers are put in contact of a material capable of inducing a exchange coupling with said M layer, such as for example IrMn, PtMn, FeMn or NiMn.

10. A method for producing a magnetic multilayer device according to any one of claims 1 to 9, wherein it comprises the following steps:

    - depositing, on an electrically insulating surface, a first metallic magnetic layer M by cathode sputtering,
    - producing the first layer O on this first layer M,
    - repeating the two previous steps or only the first of them,
    - depositing an electrical contact.

11. A method for producing a magnetic multilayer device as claimed in claim 10,

    - wherein the step for depositing the first metallic layer M is preceded by a preliminary step consisting of depositing, on the substrate, a layer made of a growth initiating material;
    - wherein the growth initiating material has a sufficiently small thickness to minimize the quantity of current derived into this layer relative to the current that flows in the active part of the magnetic device when said current is injected parallel to the plane of the layers.

12. A method for producing a magnetic multilayer device as claimed in claim 11, wherein said preliminary step is itself preceded by depositing, on the substrate, a layer of an electrically conductive material used to inject an electric current in a direction perpendicular to the plane of the layers.

13. A magnetic field sensor, wherein it consists of a magnetic multilayer device as claimed in any of claims 1 to 9 having a perpendicular anisotropy field that almost counterbalances its demagnetizing field.

14. A magnetic memory, wherein it consists of a magnetic multilayer device as claimed in any of claims 1 to 9 in which magnetization of the magnetic layers is perpendicular to the plane of the layers in the absence of any external magnetic field.

15. A magnetic logic gate, wherein it consists of a magnetic multilayer device as claimed in any of claims 1 to 9 in which magnetization of the magnetic layers is perpendicular to the plane of the layers in the absence of any external magnetic field.

**Figure 1**

Résistivité de Hall

$4\pi M_s R_s$

$4\pi M_s$

Champ Magnétique

**Figure 2**

Figure 3

Figure 4

**Figure 5**

**Figure 6**

$Pt_{1nm}/Co_{0,6nm}/Al_2O_{3\ 2nm}/(CoFe_{0,6nm}/Al_2O_{3\ 2nm})_5$

**Figure 7**

**Figure 8**

Pt 1nm/Co 0,6nm/Al$_2$O$_3$ 2nm/(CoFe 0,6nm/Al$_2$O$_3$ 2nm)$_5$

**Figure 9**

Pt 1nm/Co 0,6nm/Al$_2$O$_3$ 2nm/(CoFe 0,6nm/Al$_2$O$_3$ 2nm)$_5$

**Figure 10**

Figure 11

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- CN 1588539 A

**Littérature non-brevet citée dans la description**

- **T. W. KIM ; S. H. LIM ; R. J. GAMBINO.** Spontaneous Hall effect in amorphous Tb-Fe and Sm-Fe thin films. *Journal of Applied Physics,* 2001, vol. 89, 7212
- **G. X. MIAO ; GANG XIAO.** Giant Hall resistance in Pt-based ferromagnetic alloys. *Applied Physics Letters,* 2004, vol. 85, 73
- **A. B. PAKHOMOV ; X. YAN ; B. ZHAO.** Giant Hall effect in percolating ferromagnetic granular metal-insulator films. *Applied Physics Letters,* 1995, vol. 67, 3497
- **O. RISS ; A. TSUKERNIK ; M. KARPOVSKY ; A. GERBER.** Reorientation phase transition and sensitivity of the extraordinary Hall-effect-based sensors. *Journal of Magnetism and Magnetic Materials,* 2006, vol. 298, 73
- *Journal of Applied Physics,* 1995, vol. 77, 1969

- **B. DIENY ; S. SANKAR ; M. R. MCCARTNEY ; D. J. SMITH ; P. BAYLE-GUILLEMAUD ; A. E. BERKOWITZ.** Spin-dependent tunnelling in discontinuous metal/insulator multilayers. *Journal of Magnetism and Magnetic Materials,* 1998, vol. 185, 283
- **G. S. D. BEACH ; A. E. BERKOWITZ.** Co-Fe metal/native-oxide multilayers: a new direction in soft magnetic thin film design I. Quasi-static properties and dynamic response. *IEEE Transactions on Magnetics,* 2005, vol. 41, 2043
- **G. S. D. BEACH ; A. E. BERKOWITZ.** Co-Fe metal/native-oxide multilayers: a new direction in soft magnetic thin film design II. Microscopic characteristics and interactions. *IEEE Transactions on Magnetics,* 2005, vol. 41, 2053
- *Journal of Applied Physics,* 2005, vol. 97, 013901